Europäisches Patentamt

European Patent Office

Office européen des brevets

(11) Numéro de publication: **0 289 414**
**A2**

## (12) DEMANDE DE BREVET EUROPEEN

(21) Numéro de dépôt: 88401008.3

(22) Date de dépôt: 25.04.88

(51) Int. Cl.4: **G 01 D 3/02**
**G 01 R 33/035**

(30) Priorité: 28.04.87 FR 8706014

(43) Date de publication de la demande:
**02.11.88 Bulletin 88/44**

(84) Etats contractants désignés: **DE GB IT**

(71) Demandeur: **COMMISSARIAT A L'ENERGIE ATOMIQUE**
**31/33, rue de la Fédération**
**F-75015 Paris (FR)**

(72) Inventeur: **Bloyet, Daniel**
**16, rue des 6 Acres Epron**
**F-14610 Thaon (FR)**

**Dubuc, Christian**
**Cidex 08 Neuilly Le Malherbe**
**F-14210 Evrecy (FR)**

**Duret, Denis**
**13, rue de Stalingrad**
**F-38100 Grenoble (FR)**

**Lepaisant, Jacques**
**5 Impasse de Rocrot**
**F-14200 Herouville Saint Clair (FR)**

**Robbes, Didier**
**48 Allée Jacques Prévert**
**F-14790 Verson (FR)**

**Benhida, Khalid**
**7, rue de Bourgogne**
**F-14000 Caen (FR)**

(74) Mandataire: **Mongrédien, André et al**
**c/o BREVATOME 25, rue de Ponthieu**
**F-75008 Paris (FR)**

(54) Procédé de numérisation et de linéarisation d'un capteur à caractéristique périodique quasi sinusoidale et dispositif correspondant.

(57) Procédé de numérisation et de linéarisation d'un capteur à caractéristique périodique quasi sinusoïdale et dispositif correspondant.

Le procédé consiste à mesurer une variation ($\Delta\varphi_x$) d'un signal ($\varphi_x$) reçu par le capteur selon les opérations suivantes :

- superposer au signal à mesurer un premier signal auxiliaire périodique ($\varphi_I$), de fréquence $f_I$ supérieure à la plus haute fréquence du spectre du signal à mesurer et d'amplitude sensiblement égale à $\Phi_o/2$, et un second signal auxiliaire constitué d'une rampe linéaire périodique ($\varphi_R$) de fréquence $f_R$ très inférieure à $f_I$, et d'amplitude $\Phi_1$, le capteur recevant ainsi un signal composé constitué du signal à mesurer, du premier signal auxiliaire et du second signal auxiliaire,

-déduire, du signal délivré par le capteur, deux signaux $V_{C1}$ et $V_{C2}$ périodiques, de période $\Phi_o$, et en quadrature,

- mesurer le niveau b du second signal auxiliaire lorsque le signal $V_{C1}$ atteint un état prédéterminé, cet état ayant une périodicité $\Phi_1$ dans le signal $V_{C1}$,

- compter le nombre a de périodes $\Phi_1$ dont varie le signal à mesurer en fonction des changements d'états des signaux $V_{C1}$ et $V_{C2}$, le niveau du second signal auxiliaire étant bloqué pendant ledit comptage,

- calculer la variation $\Delta\varphi_x$ du signal à mesurer selon l'équation :

$$\Delta\varphi_x = a\,\Phi_1 + b, \quad 0 \leq b \leq \Phi_1.$$

Application notamment aux capteurs magnétiques à effet Josephson.

FIG. 2

**Description**

## PROCEDE DE NUMERISATION ET DE LINEARISATION D'UN CAPTEUR A CARACTERISTIQUE PERIODIQUE QUASI SINUSOIDALE ET DISPOSITIF CORRESPONDANT

La présente invention a pour objet un procédé de numérisation et de linéarisation d'un capteur à caractéristique périodique quasi sinusoïdale. Elle a également pour objet un dispositif pour la mise en oeuvre de ce procédé.

L'invention s'applique notamment en magnétométrie, pour les mesures de flux magnétique utilisant un capteur à effet Josephson, ainsi qu'en interférométrie optique, pour la mesure d'un chemin optique au moyen d'un interféromètre à fibres de Mach-Zehnder. De manière générale, l'invention s'applique à la mesure de toute grandeur physique au moyen d'un capteur à caractéristique périodique quasi sinusoïdale. A titre d'exemple purement illustratif, l'invention va être décrite dans son application à un capteur de flux magnétique à effet Josephson.

Le capteur de flux magnétique à effet Josephson, appelé aussi SQUID (pour "Superconducting Quantum Interference Device" qui correspond à l'appellation française "Dispositif supra conducteur à interférence quantique") est utilisé pour la mesure directe d'un champ magnétique, en biomagnétisme ou géomagnétisme par exemple. Il peut également être utilisé indirectement pour mesurer des tensions ou des courants ; la tension ou le courant à mesurer sont en général appliqués à une inductance couplée au capteur SQUID, ce qui provoque un flux traversant celui-ci. Une autre application indirecte est la mesure des températures par évaluation du bruit thermique apparaissant aux bornes d'une résistance.

On sait qu'il existe deux familles de capteurs SQUID : le capteur SQUID radiofréquence et le capteur SQUID continu. On pourra trouver une analyse complète de leur fonctionnement par exemple dans l'article de J. Clarke paru dans la revue "NATO ADVANCED STUDY INSTITUTES SERIES", série B, physics, vol.2.1, 1977, pages 67-124.

Le capteur SQUID radiofréquence est constitué d'un anneau supraconducteur interrompu par une seule jonction Josephson, maintenu à très basse température, le plus souvent dans un bain d'hélium liquide. Un circuit oscillant dont la bobine est couplée magnétiquement au capteur SQUID est excité autour de sa fréquence de résonance, c'est-à-dire en général à une fréquence de quelques dizaines à quelques centaines de mégahertz. Dans ces conditions, l'impédance radio-fréquence du circuit oscillant varie périodiquement avec le flux magnétique appliqué à l'anneau, et cette période est égale à un quantum de flux magnétique $\Phi_o = 2.10^{-15}$ Wb ($\Phi_o = h/2e$, h étant la constante de Planck et e la charge de l'électron). Les variations d'impédance sont détectées par une chaîne électronique associée qui délivre en sortie une tension électrique périodique de période $\Phi_o$, en fonction du flux magnétique à mesurer.

L'autre type de capteur SQUID est le capteur SQUID continu. Il consiste en une boucle supraconductrice interrompue en deux endroits par des jonctions Josephson identiques. En l'absence de flux magnétique appliqué à l'anneau, si le capteur SQUID est alimenté par un courant électrique $I_a$, la tension électrique V aux bornes de l'anneau est nulle jusqu'à un courant $I_a$ égal à deux fois le courant électrique critique $I_c$ des jonctions. A partir d'un courant $I_a$ égal à $2.I_c$, la caractéristique $V(I_a)$ tend vers une caractéristique ohmique.

L'application d'un flux magnétique à l'anneau provoque la circulation d'un courant électrique dans cet anneau, qui déséquilibre le courant électrique traversant les deux jonctions et qui provoque donc le passage à tension non nulle à partir d'un courant électrique $I_a$ égal à $2.1_c - \Delta I_m$. Par suite de la quantification du flux magnétique dans l'anneau supraconducteur, $\Delta I_m$ est une fonction périodique du flux magnétique dans l'anneau, de période égale à $\Phi_o$. Si le capteur SQUID est polarisé sous un courant électrique constant voisin de $2.1_c$, la tension électrique développée aux bornes du capteur SQUID est donc une fonction périodique, de période $\Phi_o$ du flux magnétique appliqué.

Pour mieux exploiter le rapport signal à bruit des signaux délivrés par les capteurs SQUID, il est connu de moduler le flux magnétique à mesurer. Cette modulation est réalisée en créant avec une bobine directement couplée à l'anneau du capteur un flux magnétique sinusoïdal de fréquence $f_l$ supérieure à la plus haute fréquence du spectre du champ magnétique à mesurer (jusqu'à quelques centaines de kilohertz) et d'amplitude crête à crête de l'ordre de $\Phi_o/2$. Après passage dans un mélangeur dont le signal local est à la fréquence $f_l$, ou dans un démodulateur inverseur synchronisé avec la modulation puis après filtrage, la tension de sortie $V_d$ du capteur SQUID est toujours une fonction périodique du flux magnétique $\varphi_x$ à mesurer et de plus elle est de valeur moyenne nulle ; la variation $V_d(\varphi)$ est d'ailleurs le plus souvent proche d'une loi sinusoïdale.

L'intérêt de ce procédé est de permettre d'amplifier à fréquence intermédiaire le signal provenant du capteur SQUID et d'éliminer sa valeur moyenne sans rajouter de bruit très basse fréquence. Dans le cas d'un capteur présentant un signal plus important, il est possible d'utiliser directement le signal, sans le procédé décrit ci-dessus.

Dans les magnétomètres connus, la linéarisation des variations de la tension de sortie en fonction des variations du flux magnétique d'entrée est assurée par une technique de contre-réaction de flux : la tension $V_d$ est amplifiée et filtrée, la tension de sortie $V_s$ ainsi obtenue permet d'injecter par l'intermédiaire d'une résistance R un courant créant, grâce à une bobine couplée au capteur SQUID, un flux magnétique de contre-réaction $\varphi_{CR}$. Cette contre-réaction a pour effet d'assurer une réponse linéaire en maintenant le flux d'erreur $\varphi_x - \varphi_{CR}$ suffisamment petit devant $\Phi_o/2$. En pratique le signal d'erreur est minimisé pour un flux d'entrée donné en augmentant le gain en boucle ouverte $A_o$.

Comme il est d'usage dans les systèmes bouclés, le gain en boucle ouverte doit cependant être réduit à l'unité pour une fréquence quelque peu inférieure à la fréquence pour laquelle les déphasages dans la boucle introduiraient une rotation de phase de $\pi$, donc une réaction positive instable. Ceci est généralement réalisé en introduisant un intégrateur dans l'étage amplificateur.

Dans ces conditions, les équations de fonctionnement du système bouclé en l'absence de bruit de fond sont les suivantes :

$$V_d = \frac{1}{A_o} \frac{dV_s}{dt} \; ;$$

$$; \; \varepsilon = \varphi_x - V_s \cdot \frac{M}{R} \; ; \; \varphi_{CR} = V_s \cdot \frac{M}{R}$$

où M est la mutuelle inductance du capteur.

Le flux total $\varepsilon$ dans le capteur SQUID, égal à $\varphi - \varphi_{CR}$, est relié à la tension $V_d$ délivrée par le capteur par la relation sinusoïdale évoquée plus haut : $V_d = V_d(\varepsilon)$. Ces équations amènent à :

$$\frac{d\varepsilon}{dt} = \frac{d\varphi}{dt} - \frac{MA_o}{R} V_d(\varepsilon).$$

Or la tension $V_d(\varepsilon)$ est périodique et limitée à $\pm V_{dm}$. Il en résulte que si on applique au système bouclé une rampe de flux de pente

$$\left| \frac{d\varphi}{dt} \right| > \frac{MA_o}{R} V_{dm}$$

il ne peut y avoir de solution $d\varepsilon/dt = 0$. Dans ce cas, le signal d'erreur va évoluer dans le temps jusqu'à amener le point de fonctionnement de $V_d(\varepsilon)$ sur une zone de pente négative, donc instable ; la tension de sortie subit alors un changement irréversible. Ces phénomènes de débouclage s'accompagnant de "sauts de flux" dans le capteur SQUID sont d'ailleurs tout à fait analogues aux déverrouillages des boucles accrochées en phase. La présence du bruit de fond, qui contribue à ajouter des fluctuations aléatoires au signal d'erreur, vient diminuer encore la vitesse maximale admissible de variation du flux d'entrée. Une étude approfondie est menée par exemple dans l'article de D. BRUNET-BRUNOL et al., paru dans la revue "Journal of applied physics", n° 50, 521-529, 1979. De même, le système bouclé est très sensible aux parasites impulsionnels.

La présente invention a pour but de remédier à ces inconvénients en évitant d'utiliser une boucle de contre-réaction. Elle a également pour but de numériser et de linéariser le signal délivré par le capteur SQUID, ou de manière générale la réponse de tout capteur à caractéristique périodique quasi-sinusoïdale, ce qui permet de simplifier par exemple le traitement ultérieur de ce signal.

De manière précise, l'invention a pour objet un procédé de numérisation et de linéarisation d'un capteur à caractéristique périodique quasi-sinusoïdale de période $\Phi_o$, pour mesurer une variation $\Delta\varphi_x$ d'un signal $\varphi_x$ reçu par ce capteur, ledit procédé étant caractérisé en ce qu'il consiste à :

- superposer audit signal à mesurer $\varphi_x$ un premier signal auxiliaire périodique $\varphi_I$, de fréquence $f_I$ supérieure à la plus haute fréquence du spectre du signal à mesurer $_x$ et d'amplitude sensiblement égale à $\Phi_o/2$, et un second signal auxiliaire périodique $\varphi_R$ constitué d'une rampe linéaire, de fréquence $f_R$ très inférieure à $f_I$, et d'amplitude $\Phi_1$, ledit capteur recevant ainsi un signal composé constitué du signal à mesurer, du premier signal auxiliaire et du second signal auxiliaire.

- déduire, du signal $V_S$ délivré par le capteur, deux signaux $V_{C1}$ et $V_{C2}$ en quadrature et de même période $\Phi_o$,

- mesurer le niveau $\underline{b}$ du second signal auxiliaire lorsque le signal $V_{C1}$ atteint un état prédéterminé, cet état ayant une périodicité $\Phi_1$ dans le signal $V_{C1}$,

- compter le nombre $\underline{a}$ de périodes $\Phi_1$ dont varie le signal à mesurer en fonction des changements d'états des signaux $V_{C1}$ et $V_{C2}$, le niveau du second signal auxiliaire étant bloqué pendant ledit comptage,

- calculer la variation $\Delta\varphi_x$ du signal à mesurer selon l'équation :
$\Delta\varphi_x = a\Phi_1 + b$, où $0 \leq b \leq \Phi_1$

Le procédé de l'invention permet ainsi d'obtenir un signal représentatif de la variation du signal à mesurer qui s'exprime linéairement en fonction du terme $\Phi_1$.

Selon un premier mode préféré, le signal $V_{C1}$ est un signal carré et le niveau $\underline{b}$ du second signal auxiliaire est mesuré sur chaque front du signal $V_{C1}$, la périodicité $\Phi_1$ de cet état étant égale à $\Phi_o/2$.

Selon une première variante, dans laquelle les signaux $V_{C1}$ et $V_{C2}$ sont carrés, on compte le nombre $\underline{a}$ de demi-périodes $\Phi_o/2$ comme fonction des transitions des signaux $V_{C1}$ et $V_{C2}$.

Selon une seconde variante, pour compter le nombre $a$ de demi-périodes $\Phi_o/2$, on procède de la manière suivante :

- on mémorise le niveau $b_i$ du second signal auxiliaire sur chaque front du signal $V_{C1}$,

- on mémorise simultanément l'état $E_i$ du signal $V_{C2}$,

- on compare l'état $E_i$ dudit signal $V_{C2}$ à son état précédent $E_{i-1}$, et on modifie de la manière suivante le nombre a si lesdits états $E_{i-1}$ et $E_i$ sont différents :

a) $\underline{a}$ est incrémenté si le dernier niveau $b_i$ mémorisé est plus grand que le niveau $b_{i-1}$ précédent,

b) a est décrémenté si le dernier niveau $b_i$ mémorisé est plus petit que le niveau $b_{i-1}$ précédent.

Selon un second mode préféré, le signal $V_{C1}$ est un signal carré et le niveau b du second signal auxiliaire est mesuré sur un front de sens déterminé dudit signal $V_{C1}$, la périodicité de la mesure du niveau du second signal auxiliaire étant alors égale à $\Phi_o$.

Selon une première variante, le signal $V_{C2}$ est également un signal carré et le nombre a est incrémenté lorsque le signal $V_{C1}$ présente un front montant alors que le signal $V_{C2}$ est au niveau haut, ce nombre a est décrémenté lorsque le signal $V_{C1}$ présente un front descendant alors que le signal $V_{C2}$ est au niveau haut, et ce nombre a n'est pas modifié lorsque le signal $V_{C2}$ est au niveau bas.

Selon une deuxième variante, le nombre a est modifié en fonction du niveau $b_i$ mesuré et du niveau $b_{i-1}$ précédent mesuré de la manière suivante :

si $b_i - b_{i-1} > \Phi_o/2$, a est incrémenté
si $|b_i - b_{i-1}| < \Phi_o/2$, a n'est pas modifié
si $b_i - b_{i-1} < -\Phi_o/2$, a est décrémenté.

L'invention a également pour objet un dispositif pour la mise en oeuvre de ce procédé.

Les caractéristiques et avantages de l'invention ressortiront mieux de la description qui va suivre, donnée à titre illustratif mais non limitatif, en référence aux dessins annexés, sur lesquels :

- la figure 1 est un diagramme montrant la caractéristique d'un capteur à caractéristique périodique quasi-sinusoïdale auquel s'applique l'invention,

- la figure 2 illustre schématiquement un dispositif pour la mise en oeuvre du procédé de l'invention,

- la figure 3 illustre un mode de réalisation d'un dispositif pour la mise en oeuvre de l'invention, dans le cas d'un capteur de flux magnétique à effet Josephson,

- la figure 4 illustre schématiquement l'allure de signaux apparaissant dans le dispositif de la figure 3,

- la figure 5 illustre un mode de réalisation du dispositif permettant d'incrémenter ou de décrémenter un compteur-décompteur dont le contenu est représentatif du nombre a, et

- la figure 6 illustre un mode de réalisation d'un dispositif pour la mise en oeuvre de l'invention, dans son application à l'interférométrie optique.

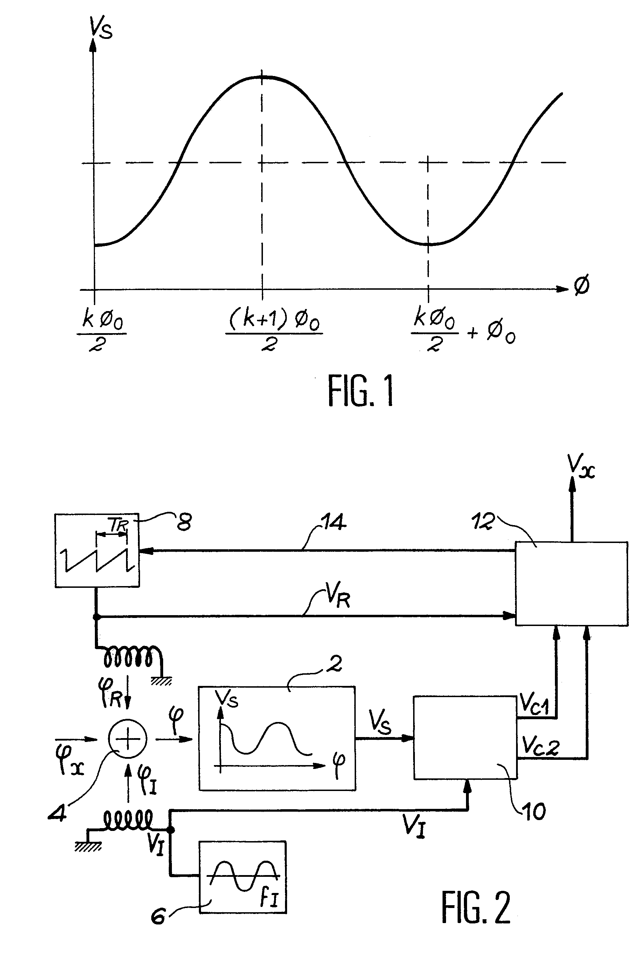

L'invention concerne la numérisation et la linéarisation du signal délivré par un capteur à caractéristique périodique quasi sinusoïdale. On a représenté sur la figure 1 un diagramme montrant la caractéristique d'un tel capteur. Le signal $V_S$ délivré par ce capteur, qui est en général un signal de tension électrique, est une fonction périodique du signal reçu par le capteur. Dans le cas d'un capteur de flux magnétique à effet Josephson, cette période $\Phi$ est égale à h/2e, où h est la constante de Planck et e la charge d'un électron.

La caractéristique représentée sur la figure 1 montre que la relation entre une variation du signal reçu par le capteur et la variaton correspondante du signal délivré par le capteur n'est pas linéaire. Le but de l'invention est de linéariser cette fonction pour permettre une exploitation plus facile du signal délivré par le capteur.

On a représenté schématiquement sur la figure 2 un dispositif pour la mise en oeuvre du procédé de l'invention. A titre d'exemple, le dispositif représenté est un magnétomètre, dont le capteur est de type capteur de flux magnétique à effet Josephson.

Ce dispositif comprend donc un capteur 2 recevant un flux magnétique φ et délivrant un signal de tension $V_S$ correspondant à ce flux magnétique. Le flux magnétique φ reçu par le capteur 2 résulte de la superposition, représentée symboliquement par un additionneur 4, d'un flux magnétique $\varphi_x$ dont on désire mesurer les variations, d'un flux magnétique $\varphi_I$ périodique de fréquence $f_I$ et d'un flux magnétique $\varphi_R$ périodique de période $T_R$.

Le flux $\varphi_I$ est utilisé pour moduler le flux magnétique $\varphi_x$ dont on désire mesurer les variations. Ce flux magnétique $\varphi_I$ est produit par une bobine recevant un courant électrique de forme sinusoïdale délivré par un générateur 6. De la même manière, le flux magnétique $\varphi_R$ est produit par une bobine recevant un courant électrique en dents de scie délivré par un générateur 8.

Le dispositif comporte également un moyen de démodulation 10 pour produire, à partir du signal $V_S$ délivré par le capteur 2, deux signaux $V_{C1}$ et $V_{C2}$, ayant la même période $\Phi_o$ que le signal $V_S$ et étant en quadrature. Pour produire les deux signaux $V_{C1}$ et $V_{C2}$, le moyen 10 reçoit le signal $V_S$ délivré par le capteur 2 et au moins le signal $V_I$ délivré par le générateur 6.

Le dispositif comprend enfin un moyen de traitement 12 recevant les signaux $V_{C1}$, $V_{C2}$ délivrés par le moyen de démodulation 10, et le signal $V_R$ délivré par le générateur 8. En fonction de ces trois signaux, le moyen de traitement 12 délivre un signal $V_{x,N}$ qui représente une variation du flux magnétique $\varphi_x$, le signal $V_{x,N}$ variant linéairement avec le flux magnétique $\varphi_x$.

Le signal $V_{x,N}$ produit par le moyen de traitement 12 peut être obtenu en combinant de diverses manières le signal $V_R$ délivré par le générateur 8 avec les signaux $V_{C1}$ et $V_{C2}$ délivrés par le moyen de démodulation 10. Des exemples de procédé de traitement seront donnés dans la suite de la description. Dans chacun de ces procédés, il est nécessaire que le moyen de traitement 12 puisse stopper le générateur 8 ou remettre à zéro le signal délivré par ce générateur ; à cette fin, il est prévu une ligne de commande 14 entre le moyen de traitement 12 et le générateur 8.

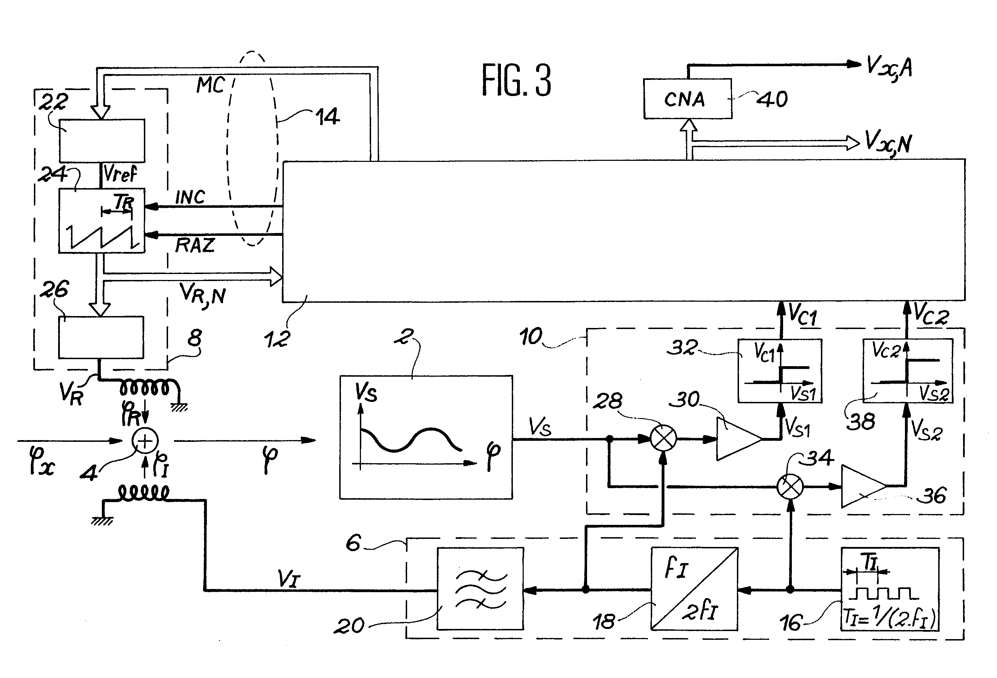

On a représenté sur la figure 3 un mode de réalisation d'un dispositif pour la numérisation et la linéarisation d'un capteur de flux magnétique à effet Josephson.

Les deux flux magnétiques auxiliaires $\varphi_I$ et $\varphi_R$ sont chacun appliqués au capteur 2 par l'intermédiaire d'une bobine qui reçoit des courants électriques proportionnels à ces flux, ces bobines étant confondues avec la bobine radiofréquence dans le cas d'un capteur SQUID radiofréquence.

Dans le mode de réalisation de la figure, le générateur 6, qui délivre un signal de tension $V_I$

permettant d'engendrer le flux magnétique auxiliaire $\varphi_I$, se compose d'un générateur 16 de signal carré périodique, de fréquence $2.f_I$, d'un diviseur par deux 18 et d'un filtre sélectif 20 centré sur la fréquence $f_I$, qui permet de transformer le signal carré reçu en un signal sensiblement sinusoïdal.

De même, le générateur 8 comporte un convertisseur numérique-analogique 22 recevant du moyen de traitement 12 un mot de contrôle MC et délivrant une tension de référence $V_{ref}$, un compteur de rampe 24 comportant une entrée de commande d'amplitude de rampe sur laquelle est appliqué le signal $V_{ref}$, une entrée de commande d'incrémentation INC, ledit compteur de rampe délivrant un signal numérique $V_{R,N}$ en dents de scie de période $T_R$, et une entrée de commande de remise à zéro RAZ, et un convertisseur numérique-analogique 26 recevant le signal délivré par le compteur 24, le signal analogique obtenu étant utilisé pour engendrer le second flux magnétique auxiliaire $\varphi_R$.

Le moyen de démodulation 10 comprend deux ensembles en parallèle, pour produire respectivement un premier signal $V_{S1}$ et un deuxième signal $V_{S2}$, à partir du signal $V_S$ délivré par le capteur 2. Les deux signaux $V_{S1}$ et $V_{S2}$ produits sont périodiques et en quadrature. Le premier ensemble comprend, en série, un modulateur 28, un amplificateur 30 et un comparateur à seuil 32. Le modulateur 28 reçoit le signal $V_S$ délivré par le capteur 2 et le signal carré, de fréquence $f_I$, délivré par le diviseur 18 du générateur 6. Après amplification dans l'amplificateur 30, le signal $V_{S1}$ délivré par le modulateur 28 est converti en un signal $V_{C1}$ à deux niveaux par le comparateur à seuil 32.

De la même manière, le second ensemble du moyen de modulation 10 comporte un modulateur 34 recevant le signal $V_S$ délivré par le capteur 2 et un signal carré, de fréquence $2.f_I$, délivré par le générateur 16 du générateur 6, un amplificateur 36 et un comparateur à seuil 38 qui délivre un signal $V_{C2}$ à deux niveaux.

L'étalonnage de la rampe délivrée par le compteur 24 est réalisé à l'aide du signal $V_{S1}$ de la manière suivante. Un mot de contrôle MC de grande amplitude est envoyé au convertisseur numérique analogique 22, qui contrôle la référence du compteur 24, de telle façon que la rampe puisse atteindre une amplitude suffisante pour que la tension $V_{S1}$ passe par trois zéros successifs. Le contenu de compteur 24 est lu au passage du premier et du troisième zéro de $V_{S1}$ et la différence est calculée par le moyen de traitement 12. Cette différence correspond à une excursion d'un quantum $\Phi_o$, mais elle est entachée d'incertitude à cause des phénomènes de bruit de fond ; afin de limiter cette incertitude, on opère un grand nombre de mesures successives afin de calculer une valeur moyenne qui soit suffisamment proche de la valeur réelle. Cette valeur moyenne permet de déduire, par un calcul réalisé par le moyen de traitement 12, la valeur théorique que doit prendre la tension $V_{ref}$, donc le mot de contrôle MC, pour que le contenu maximal du compteur 24 corresponde à une dent de scie d'amplitude voulue. Le mot de contrôle MC est alors réglé par le moyen de traitement 12 à la valeur calculée, ce qui termine le processus d'étalonnage et rend l'appareil prêt pour la mesure.

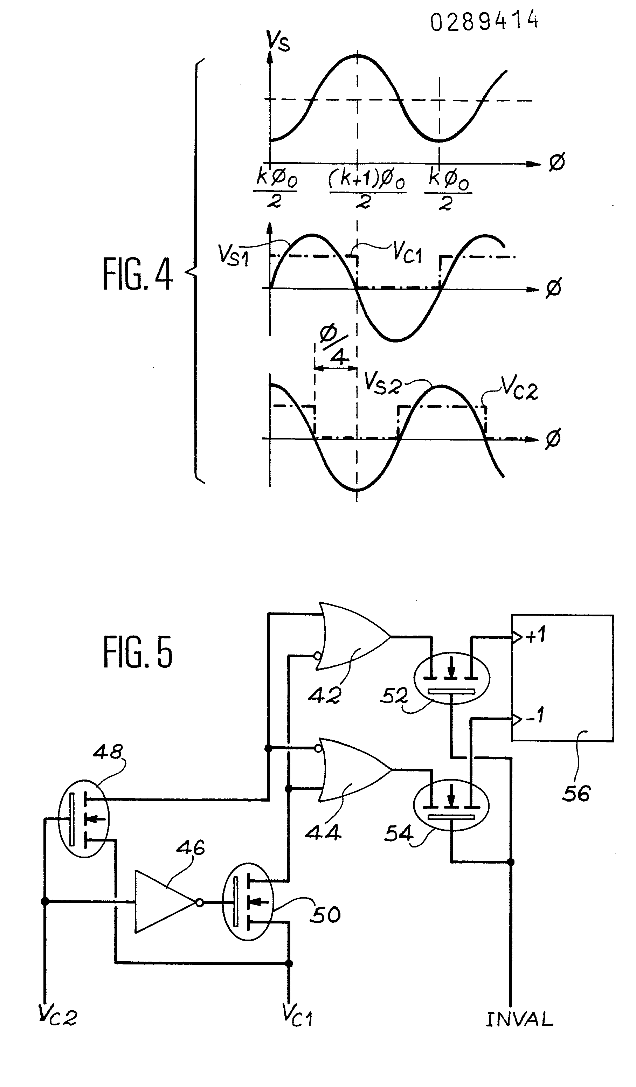

On a représenté sur le diagramme de la figure 4 la caractéristique du capteur 2 et, en correspondance, le signal $V_{S1}$ délivré par l'amplificateur 30, le signal $V_{C1}$ délivré par le comparateur 32, le signal $V_{S2}$ délivré par l'amplificateur 36 et le signal $V_{C2}$ délivré par le comparateur 38.

Les signaux $V_{C1}$ et $V_{C2}$ délivrés par le moyen de modulation 10 sont utilisés par le moyen de traitement 12 en combinaison avec le signal $V_{R,N}$ délivré par le compteur 24 pour produire le signal $V_{x,N}$ représentatif des variations du flux magnétique $\varphi_x$. Ce moyen de traitement réalise des opérations de séquencement, de calcul, de commande et d'étalonnage. Il peut avantageusement comporter un microprocesseur, des mémoires associées et, éventuellement, des circuits logiques pour réaliser certaines opérations sur les signaux $V_{C1}$, $V_{C2}$ et $V_{R,N}$.

Le procédé de numérisation et de linéarisation mis en oeuvre par le moyen de traitement 12 consiste à produire un signal $V_{x,N}$, représentatif d'une variation $\Delta\varphi_x$ d'un flux magnétique $\varphi_x$ comme fonction linéaire du quantum de flux $\Phi_o$. Plus précisément, le moyen de traitement 12 calcule des coefficients a et b tels que:

$V_{x,N} = a.\Phi_1 + b,$

où $\Phi_1$ représente une période ou une demi-période du quantum de flux magnétique $\Phi_o$.

Selon un premier mode de mise en oeuvre du procédé de l'invention, le moyen de traitement compte le nombre a de demi-périodes $\Phi_o/2$ à partir des signaux $V_{C1}$ et $V_{C2}$.

Le procédé de calcul des coefficients a et b est la suivant. Après une remise à zéro du générateur 24 par la ligne RAZ, le moyen de traitement 12 fait croître linéairement le signal délivré par le générateur 24 en délivrant périodiquement un signal d'incrémentation INC vers ce générateur. Ceci engendre un flux magnétique $\varphi_R$ qui croît linéairement et qui se superpose au flux $\varphi_x$ dont on désire mesurer les variations. Les signaux $V_{S1}$ et $V_{S2}$ délivrés par les amplificateurs 30 et 36 varient de manière sinusoïdale en fonction de la somme $\varphi_a$ des flux magnétiques $\varphi_x$ et $\varphi_R$.

Dès que l'un de ces deux signaux (par exemple $V_{S1}$) passe par zéro, on cesse d'incrémenter le signal délivré par le générateur 24. Si on note $\Phi_R$ l'amplitude atteinte par le flux magnétique $\varphi_R$ à cet instant, on a

$\varphi_a = \varphi_x + \Phi_R = k.\Phi_o/2$

ce qui peut s'écrire sous la forme :

$\varphi_x = (k-1) \Phi_o/2 + (\Phi_o/2 - \Phi_R)$

Le coefficient b est donc obtenu simplement par la lecture du signal délivré par le générateur 24 lorsque le signal $V_{S1}$, par exemple, passe par zéro.

L'expression numérique de toute variation du flux magnétique $\varphi_x$ peut alors être déterminée en évaluant le facteur k, à condition que le flux magnétique $\varphi_x$ ne subisse pas de variation significative pendant le temps de croissance du flux magnétique $\varphi_R$. Pour satisfaire cette condition, il suffit de choisir, pour la période $T_R$ du signal délivré par le générateur 24, une valeur suffisamment petite. L'évolution du facteur k est alors suivie indépendamment de l'interpolation (i.e. calcul du coefficient b) par un compteur-décompteur de demi-quantum $\Phi_o/2$ qui est commandé par les signaux $V_{C1}$ et $V_{C2}$. Pendant ce comptage- décomptage, le générateur 24 n'est pas incrémenté ; le signal $\varphi_R$ délivré est constant et égal à la valeur qu'il avait lorsque le signal $V_{S1}$ est passé par zéro.

Un mode de réalisation d'un circuit pour la détermination du facteur k est représenté sur la figure 5.

Ce circuit comprend deux portes OU 42, 44, un inverseur 46, quatre interrupteurs 48, 50, 52 et 54 constitués par des transistors MOS, et un compteur-décompteur 56. Les deux portes OU 42, 44 comportent chacune une entrée non-inverseuse et une entrée inverseuse.

Le signal $V_{C1}$ est appliqué sur l'entrée non-inverseuse de la porte OU 42 et sur l'entrée inverseuse de la porte OU 44 à travers l'interrupteur 48 commandé par le signal $V_{C2}$. Le signal $V_{C1}$ est également appliqué sur l'entrée inverseuse de la porte OU 42 et sur l'entrée non-inverseuse de la porte OU 44 à travers l'interrupteur 50 commandé par le signal $V_{C2}$ inversé par l'inverseur 46.

La sortie de la porte OU 42 est reliée à l'entrée d'incrémentation du compteur-décompteur 56 par l'intermédiaire de l'interrupteur 52. De même, la sortie de la porte OU 44 est reliée à l'entrée de décrémentation du compteur-décompteur 56 par l'intermédiaire de l'interrupteur 54. Les interrupteurs 52 et 54 sont maintenus à l'état ouvert par un signal d'invalidation INVAL tant que le générateur 24 n'est pas bloqué (c'est-à-dire tant que le signal $V_{S1}$ n'est pas passé par zéro).

Le circuit représenté sur la figure 5 fonctionne de la manière suivante. Lorsque le signal $V_{C2}$ est au niveau haut, l'interrupteur 48 est fermé et l'interrupteur 50 est ouvert ; le front montant du signal $V_{C1}$ engendre alors l'incrémentation du compteur 56, et le front descendant de ce même signal $V_{C1}$ engendre la décrémentation du compteur 56. Inversement, si le signal $V_{C2}$ est au niveau bas, l'interrupteur 48 est ouvert et l'interrupteur 50 est fermé. Le compteur 56 est alors incrémenté sur le front descendant du signal $V_{C1}$, et décrémenté sur le front montant de ce signal. Le compteur 56 mémorise donc le coefficient a.

Le moyen de traitement 12 du dispositif représenté sur la figure 3 délivre alors un signal numérique $V_{x,N}$ défini par :

$$V_{x,N} = a\,\Phi_o/2 + b$$

Ce signal peut également être appliqué sur l'entrée d'un convertisseur numérique-analogique 40 pour délivrer un signal $V_{x,A}$ correspondant.

Une autre méthode présentant l'avantage de synchroniser le calcul des coefficients a et b, peut être mise en oeuvre par le moyen de traitement 12. La méthode de calcul du coefficient b est identique à la méthode précédente, mais la mémorisation de la valeur du signal $V_{R,N}$ délivré par le générateur 24 lorsque le signal $V_{C1}$ (par exemple) passe par la valeur zéro est complétée par la mémorisation de l'état du signal $V_{C2}$, au moyen d'un drapeau de zéro. Ceci est répété pour chaque rampe délivrée par le générateur 24. Si, pour deux rampes successives le drapeau de zéro ne change pas, le coefficient a n'est pas modifié. En revanche, si un changement d'état du drapeau de zéro est observé, on compare la dernière valeur du coefficient b mémorisée à la valeur mémorisée pour la rampe précédente. Si la dernière valeur est supérieure à la valeur précédente, le coefficient a est incrémenté ; dans le cas contraire, le coefficient a est décrémenté.

Il convient de noter une limitation de cette méthode qui est mise en défaut dès que la variation du flux magnétique $\varphi_x$ dépasse un demi-quantum $\Phi_o/2$, entre deux instants de calcul du coefficient b.

Les deux méthodes qui viennent d'être décrites reposent sur la détection du passage par zéro du signal $V_{C1}$. En pratique, ce passage par zéro peut ne pas avoir une périodicité égale à $\Phi_o/2$. C'est notamment le cas si le signal $V_{S1}$ présente une tension de décalage car alors les alternances positives et les alternances négatives du signal $V_{S1}$ n'auront plus la même longueur.

On peut remédier à ceci en choisissant de bloquer le générateur 24 sur un évènement qui présente une périodicité plus précise. Cet évènement peut être par exemple un front, montant ou descendant, du signal $V_{C1}$, dont la période est strictement égale à $\Phi_o$.

La méthode de calcul des coefficients a et b peut être identique aux deux méthodes déjà présentées, la seule différence étant que l'amplitude du signal en dents de scie délivré par le générateur 24 est égale à $\Phi_o$ au lieu de $\Phi_o/2$. Cette valeur est ajustée simplement par l'intermédiaire du mot de contrôle MC délivré par le moyen de traitement 12 au convertisseur analogique-numérique 22. Le signal $V_{x,N}$ délivré par le moyen de traitement 12 est alors défini par :

$$V_{x,N} = a\,\Phi_o + b$$

Une autre variante possible consiste à comparer les coefficients $b_i$ et $b_{i+1}$ correspondant aux amplitudes de deux rampes successives, puis à modifier la valeur du coefficient a de la manière suivante :

si $b_{i+1} - b_i < -\Phi_o/2$, a est décrémenté

si $|b_{i+1} - b_i| < \Phi_o/2$, a inchangé

si $b_{i+1} - b_i > \Phi_o/2$, a est incrémenté.

L'invention a été décrite en référence aux figures 2 à 5 dans son application à un capteur de flux magnétique à effet Josephson.

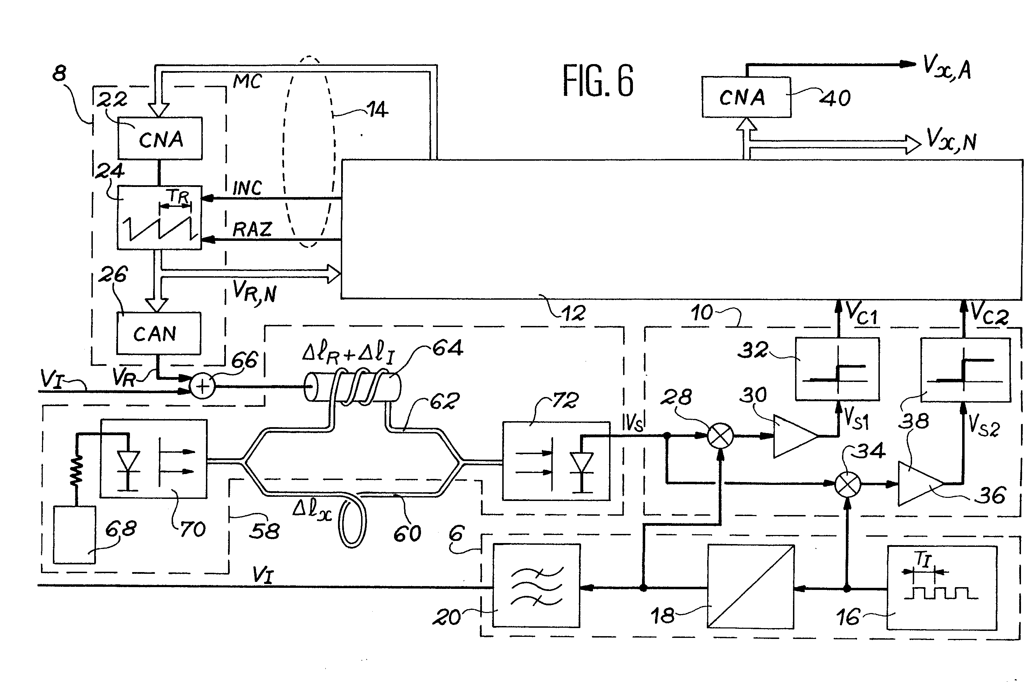

Cependant, l'invention n'est pas limitée à cette application mais peut au contraire être utilisée pour la numérisation et la linéarisation de tout capteur ayant une caractéristique périodique quasi sinusoïdale. A titre d'exemple, on a représenté sur la figure 6 un dispositif pour la mise en oeuvre de l'invention dans le cas d'un capteur du type interféromètre à fibre de MACH-ZEHNDER.

Dans le dispositif représenté sur la figure 6, les éléments identiques à ceux du dispositif de la figure 3 portent les mêmes références. En fait, les seules différences résident dans la nature du capteur et dans la conversion des signaux auxiliaires $V_R$ et $V_I$ non plus en un flux magnétique, mais en une variation de longueur de chemin optique.

De manière précise, le capteur 58 est un interféromètre comprenant une fibre optique 60 définissant un chemin optique dont on désire mesurer une

variation de longueur $l_x$, et une seconde fibre optique définissant un chemin de référence, cette seconde fibre optique 62 étant en partie enroulée autour d'un cylindre piézoélectrique 64 ce qui permet, en commandant l'application d'une tension sur ce cylindre piézoélectrique, de faire varier la longueur de chemin optique de référence. Dans l'application envisagée, le cylindre piézoélectrique 64 reçoit d'un additionneur 66 la somme des tensions $V_R$ et $V_l$ délivrées par les générateurs 8 et 6.

Les faisceaux lumineux émis dans les deux fibres 60, 62 sont produits par une diode laser 70 alimentée par un circuit d'alimentation électrique 68. En sortie du capteur, un photo-détecteur 72 reçoit les deux faisceaux lumineux superposés et délivre un signal de tension $V_S$ correspondant.

Le calcul d'une variation $\Delta l_x$ de longueur de la fibre optique de mesure 60 est déterminé par le moyen de traitement 12 par combinaison du signal $V_{R,N}$ délivré par le générateur de rampe 24, et les signaux $V_{C1}$ et $V_{C2}$ délivrés par le moyen de démodulation 10, de la même manière que dans le dispositif suivant la figure 3.

## Revendications

1. Procédé de numérisation et de linéarisation d'un capteur (2) à caractéristique périodique quasi-sinusoïdale de période $\Phi_o$, pour mesurer une variation ($\Delta\varphi_x$) d'un signal à mesurer ($\varphi_x$) reçu par ce capteur, ledit procédé étant caractérisé en ce qu'il consiste à :

- superposer audit signal à mesurer un premier signal auxiliaire périodique ($\varphi_l$), de fréquence $f_l$ supérieure à la plus haute fréquence du spectre du signal à mesurer et d'amplitude sensiblement égale à $\Phi_o/2$, et un second signal auxiliaire constitué d'une rampe linéaire périodique ($\varphi_R$) de fréquence $f_R$ très inférieure à $f_l$, et d'amplitude $\Phi_1$, ledit capteur recevant ainsi un signal composé constitué du signal à mesurer, du premier signal auxiliaire et du second signal auxiliaire,

- déduire, du signal délivré par le capteur, deux signaux $V_{C1}$ et $V_{C2}$ en quadrature et de même période $\Phi_o$,

- mesurer le niveau $\underline{b}$ du second signal auxiliaire lorsque le signal $V_{C1}$ atteint un état prédéterminé, cet état ayant une périodicité $\Phi_1$ dans le signal $V_{C1}$,

- compter le nombre $\underline{a}$ de périodes $\Phi_1$ dont varie le signal à mesurer en fonction des changements d'états des signaux $V_{C1}$ et $V_{C2}$, le niveau du second signal auxiliaire étant bloqué pendant ledit comptage,

- calculer la variation $\Delta\varphi_x$ du signal à mesurer selon l'équation :

$\Delta\varphi_x = a\,\Phi_1 + b, 0 \leqq b \leqq \Phi_1$.

2. Procédé selon la revendication 1, caractérisé en ce que le signal $V_{C1}$ est un signal carré et en ce que le niveau $\underline{b}$ du second signal auxiliaire est mesuré sur chaque front dudit signal $V_{C1}$, la périodicité $\Phi_1$ de ladite mesure étant égale à $\Phi_o/2$.

3. Procédé selon la revendication 2, caractérisé en ce que le signal $V_{C2}$ est un signal carré et en ce qu'on compte le nombre $\underline{a}$ de demi-périodes $\Phi_o/2$ comme fonction des transitions des signaux $V_{C1}$ et $V_{C2}$.

4. Procédé selon la revendication 2, caractérisé en ce que pour compter le nombre $\underline{a}$ de demi-périodes $\Phi_o/2$, on procède de la manière suivante :

- on mémorise le niveau $b_i$ du second signal auxiliaire sur chaque front du signal $V_{C1}$,

- on mémorise l'état $E_i$ du signal $V_{C2}$ à cet instant,

- on compare l'état $E_i$ dudit signal $V_{C2}$ à son état précédent $E_{i-1}$, et on modifie de la manière suivante le nombre $\underline{a}$ si lesdits états $E_{i-1}$ et $E_i$ sont différents :

a) $\underline{a}$ est incrémenté si le dernier niveau $b_i$ mémorisé est plus grand que le niveau $b_{i-1}$ précédent,

b) $\underline{a}$ est décrémenté si le dernier niveau $b_i$ mémorisé est plus petit que le niveau $b_{i-1}$ précédent.

5. Procédé selon la revendication 1, caractérisé en ce que le signal $V_{C1}$ est un signal carré et en ce que le niveau $\underline{b}$ du second signal auxiliaire est mesuré sur un front de sens déterminé dudit signal $V_{C1}$, la périodicité $\Phi$ de ladite mesure étant égale à $\Phi_o$.

6. Procédé selon la revendication 5, caractérisé en ce que le signal $V_{C2}$ est également un signal carré et en ce que le nombre $\underline{a}$ est incrémenté lorsque le signal $V_{C1}$ présente un front montant alors que le signal $V_{C2}$ est au niveau haut, ce nombre $\underline{a}$ est décrémenté lorsque le signal $V_{C1}$ présente un front descendant alors que le signal $V_{C2}$ est au niveau haut, et le nombre $\underline{a}$ n'est pas modifié lorsque le signal $V_{C2}$ est au niveau bas.

7. Procédé selon la revendication 5, caractérisé en ce que le nombre $\underline{a}$ est modifié en fonction du niveau $b_i$ mesuré et du niveau $b_{i-1}$ précédent mesuré de la manière suivante :

si $b_i - b_{i-1} > \Phi_o/2$, $\underline{a}$ est incrémenté

si $|b_i - b_{i-1}| < \Phi_o/2$, $\underline{a}$ n'est pas modifié

si $b_i - b_{i-1} < -\Phi_o/2$, $\underline{a}$ est décrémenté.

8. Dispositif pour la numérisation et la linéarisation de la réponse d'un capteur à caractéristique périodique quasi-sinusoïdale, de période $\Phi_o$, pour mesurer une variation ($\Delta\varphi_x$) d'un signal à mesurer ($\varphi_x$) reçu par ledit capteur (2), ledit dispositif étant caractérisé en ce qu'il comprend :

- un premier générateur (6) d'un signal électrique $V_l$ auxiliaire périodique, de fréquence $f_l$ supérieure à la plus haute fréquence du spectre du signal à mesurer, ledit signal électrique $V_l$ étant ensuite converti en un signal ($\varphi_l$) détectable par le capteur, et ayant une amplitude sensiblement égale à $\Phi_o$,

- un second générateur (8) d'un signal électrique $V_R$ auxiliaire constitué d'une rampe linéaire périodique, de fréquence $f_R$ très infé-

rieure à $f_l$, ledit signal électrique $V_R$ étant ensuite converti en un signal ($\varphi_R$) détectable par le capteur, et ayant une amplitude $\Phi_1$,

- un moyen de démodulation (10) pour recevoir le signal $V_S$ de période $\Phi_o$ délivré par le capteur et au moins le signal $V_l$ délivré par le générateur 6, et pour produire deux signaux $V_{C1}$, $V_{C2}$ en quadrature et de même période $\Phi_o$, et

- un moyen de traitement (12) pour combiner les signaux $V_{C1}$, $V_{C2}$ délivrés par le moyen de démodulation (10), et le signal $V_R$ délivré par le générateur (8) pour calculer des coefficients $\underline{a}$ et $\underline{b}$ et produire un signal $V_x$ correspondant à la variation mesurée ($\Delta\varphi_x$) du signal à mesurer selon l'équation :

$V_x = a.\Phi_1 + b$, où $a \leqq b < \Phi_1$.

9. Dispositif selon la revendication 8, caractérisé en ce que le générateur (6) comprend, en série :

- un générateur (16) de signal carré de fréquence $1/(2.f_l)$,

- un diviseur par deux (18), et

- un filtre sélectif (20) délivrant le signal $V_l$, ledit filtre transformant le signal carré reçu en un signal quasi-sinusoïdal.

10. Dispositif selon la revendication 9, caractérisé en ce que le moyen de démodulation (8) comprend deux ensembles en parallèle recevant chacun le signal $V_S$ délivré par le capteur (2), et délivrant respectivement les signaux $V_{C1}$ et $V_{C2}$ en quadrature, un ensemble comprenant en série un modulateur (28) recevant le signal $V_S$ et le signal délivré par le diviseur (18), un amplificateur (30) et un comparateur à seuil (32), l'autre ensemble comprenant en série un modulateur (34) recevant le signal $V_S$ et le signal délivré par le générateur (16), un amplificateur (36) et un comparateur à seuil (38).

(11). Dispositif selon l'une quelconque des revendications 8 à 10, caractérisé en ce que le moyen de traitement (12) mesure le niveau $\underline{b}$ du signal auxiliaire $V_R$ lorsque le signal $V_{C1}$ atteint un état prédéterminé, cet état ayant une périodicité $\Phi_1$ dans le signal $V_{C1}$ ; compte le nombre $\underline{a}$ de périodes $\Phi_1$ dont varie le signal à mesurer ($\varphi_x$) en fonction des changements d'états des signaux $V_{C1}$ et $V_{C2}$, le niveau dudit signal $V_R$ étant bloqué pendant ledit comptage ; calcule la variation $\Delta\varphi_x$ dudit signal à mesurer selon l'équation $\Delta\varphi_x = a\Phi_1 + b$, $0 \leqq b \leqq \Phi_1$ ; et, délivre un signal $V_x$ représentatif de ladite variation $\Delta\varphi_x$.

0289414

FIG. 1

FIG. 2

FIG.3

FIG. 4

$V_S$

$\dfrac{k\phi_0}{2}$  $\dfrac{(k+1)\phi_0}{2}$  $\dfrac{k\phi_0}{2}$  $\phi$

$V_{S1}$  $V_{C1}$  $\phi$

$\dfrac{\phi}{4}$

$V_{S2}$  $V_{C2}$  $\phi$

0289414

FIG. 5

48

42

52

+1

44

54

-1

56

46

50

$V_{C2}$  $V_{C1}$  INVAL

FIG. 6